# EUROPÄISCHE PATENTSCHRIFT

(11) **EP 1 282 917 B1**
(45) Veröffentlichungstag und Bekanntmachung des Hinweises auf die Patenterteilung: **22.07.2009**
(21) Anmeldenummer: 01947134.1
(22) Anmeldetag: 11.05.2001
(51) Int. Cl.: H01L 27/108, H01L 29/78, H01L 21/336, H01L 21/8242, H01L 29/786

(54) **VERTIKALER TRANSISTOR**
VERTICAL TRANSISTOR
TRANSISTOR VERTICAL

(30) Priorität: 16.05.2000 DE 10024876
(43) Veröffentlichungstag der Anmeldung: 12.02.2003
(73) Patentinhaber: Infineon Technologies AG, 81669 München (DE)
(72) Erfinder: WEIS, Rolf, Wappingers Falls, NY 12590 (US)
(74) Vertreter: Epping - Hermann - Fischer
(86) Internationale Anmeldenummer: PCT/DE2001/001800
(87) Internationale Veröffentlichungsnummer: WO 2001/088984

(56) Entgegenhaltungen:
- DE-A- 19 845 004
- DE-A- 19 845 058
- US-A- 5 177 576
- US-A- 6 020 239

## Beschreibung

Die vorliegende Erfindung betrifft einen vertikalen Transistor, der ein unteres Dotiergebiet, ein oberes Dotiergebiet und einen Kanal aufweist, sowie ein Verfahren zu seiner Herstellung.

Bei vertikalen Transistoren handelt es sich um Feldeffekttransistoren, deren Source-Gebiet und Drain-Gebiet übereinander und nicht planar nebeneinander angeordnet ist, wie es bei planaren Feldeffekttransistoren der Fall ist. Vertikale Transistoren sind aus DE 198 45 004 A1, DE 198 45 058 A1, US 6,020,239 und US 5,177,576 bekannt.

Zum Beispiel sind in dem Patent US 5,177,576 vertikale Transistoren angegeben, die einen Floating-Body-Effekt aufweisen. Der Floating-Body-Effekt bedeutet, daß das Kanalgebiet des Transistors nicht kontaktiert ist und daher elektrisch schwebt (floatet).

Auch bei planaren Transistoren ist der Floating-Body-Effekt bekannt. Er tritt beispielsweise bei sogenannten SOI-Transistoren (Silicon on Insulator) auf, bei denen das Kanalgebiet zwischen Source-Gebiet, Drain-Gebiet, seitlichen Isolationen und SOI-Isolation eingeschlossen ist, so daß es keinen Kontakt zu einem Substrat aufweist.

Der Kontakt zu einem Substrat ermöglicht bei nicht SOI-Transistoren, daß Ladungen, die in dem Kanalgebiet entstehen, in das Substrat abwandern und der Kanal dadurch keine elektrischen Aufladungseffekte aufweist. Im Gegensatz dazu ist der Kanal bei SOI-Transistoren isoliert, was bei z.B. kapazitivem Übersprechen benachbarter Strukturen entsprechend zu Aufladungseffekten in dem Kanal führt, da die entstandenen Ladungen nicht mehr abtransportiert werden können. Die Aufladungseffekte im Kanal bewirken eine Steuerwirkung auf den Kanal, die der Gate-Elektrode ähnlich ist. Diese Steuerwirkung führt dazu, daß der Transistor nicht mehr definiert ein- und ausgeschaltet werden kann. Ein Transistor, der nicht mehr steuerbar ist, verliert seine Funktionalität und ist damit unbrauchbar.

Es ist die Aufgabe der Erfindung einen vertikalen Transistor anzugeben, bei dem der Floating-Body-Effekt vermieden wird. Weiterhin ist es die Aufgabe der Erfindung, ein entsprechendes Herstellungsverfahren anzugeben.

Die Aufgabe wird erfindungsgemäß durch einen vertikalen Transistor in einem Substrat gelöst mit: einem unteren Dotiergebiet, das in dem Substrat angeordnet ist; einem oberen Dotiergebiet, das in dem Substrat oberhalb des unteren Dotiergebiets angeordnet ist; mit einem Kanalgebiet, das zwischen dem unteren Dotiergebiet und dem oberen Dotiergebiet angeordnet ist; mit einem Isolationsgraben, der mit einem isolierenden Material gefüllt ist und an das Kanalgebiet heranreicht, wobei der Isolationsgraben eine untere Isolationsfüllung unterhalb einer oberen Isolationsfüllung und eine leitende Schicht zwischen der unteren Isolationsfüllung und der oberen Isolationsfüllung aufweist, wobei die leitfähige Schicht das Kanalgebiet elektrisch an das Substrat anschließt.

Üblicherweise wird ein vertikaler Transistor mit Hilfe eines Isolationsgrabens isoliert. Dies wird z.B. in einem Speicher mit einem Speicherzellenfeld durchgeführt, bei dem benachbarte Speicherzellen, die aus einem Grabenkondensator und einem vertikalen Transistor als Auswahltransistor bestehen, voneinander isoliert sind. Die einzelnen Speicherzellen des Speicherzellenfeldes sind dabei aus Platzersparnis so dicht nebeneinander angeordnet, daß das Kanalgebiet des vertikalen Transistors zwischen Gate-Oxid, Isolationsgraben und den Dotiergebieten vollständig isoliert ist. Erfindungsgemäß kann auch in so einer Speicherzellenanordnung der Isolationsgraben mit einer leitenden Schicht, die zwischen einer oberen Isolationsfüllung und einer unteren Isolationsfüllung angeordnet ist ausgebildet sein, so daß das Kanalgebiet des vertikalen Transistors an das Substrat angeschlossen ist.

Die Erfindung sieht vor, daß die leitende Schicht das Kanalgebiet elektrisch kontaktiert. Dadurch wird sichergestellt, daß ein elektrischer Kontakt die Aufladung des Kanalgebietes verhindert.

Eine vorteilhafte Ausgestaltung der Erfindung sieht vor, daß die obere Isolationsfüllung an das obere Dotiergebiet heranreicht. Durch diese Anordnung wird ein platzsparendes Layout ermöglicht, das zusätzlich den Vorteil aufweist, daß das obere Dotiergebiet sehr gut von dem Substrat und einer benachbarten Schaltung isoliert ist, wodurch Leckströme verringert werden.

Weiterhin ist es vorteilhaft, daß die untere Isolationsfüllung an das untere Dotiergebiet heranreicht. Durch diese Anordnung ist der Isolationsgraben so tief in dem Substrat gebildet, daß auch das untere Dotiergebiet weitestgehend von dem Substrat isoliert ist und auch hier Leckströme zu benachbarten Schaltungsteilen vermieden werden.

Weiterhin ist es vorteilhaft, die leitende Schicht aus Silizium, dotiertem Silizium, polykristallinem Silizium, amorphem Silizium, Wolframnitrid, Titannitrid, Tantalnitrid oder einem Silizid zu bilden. Bei den siliziumhaltigen Materialien steht die gute Verträglichkeit mit dem Kanalgebiet, welches üblicherweise aus Silizium gebildet ist, im Vordergrund. Die Dotierung des Siliziums wird dabei so gewählt, daß ein guter elektrischer Anschluß gewährleistet wird. Die Auswahl eines der genannten Nitride hat den Vorteil, daß sie als Barriere wirken und so unerwünschte Materialdiffusion verhindern. Weiterhin haben die genannten Nitride den Vorteil, eine gute Leitfähigkeit aufzuweisen. Silizide können ebenfalls wegen ihrer guten Leitfähigkeit eingesetzt werden.

Eine weitere vorteilhafte Ausprägung der erfindungsgemäßen Anordnung sieht vor, daß die untere Isolationsfüllung und die obere Isolationsfüllung zumindest teilweise aus Siliziumoxid, Siliziumnitrid und/oder Siliziumoxynitrid gebildet sind. Die Verwendung dieser Materialien gewährleistet gute Isolationseigenschaften des oberen und des unteren Dotiergebiets gegen leitfähige, benachbarte Strukturen.

Die gestellte Aufgabe wird ebenfalls durch ein erfindungsgemäßes Verfahren zur Herstellung eines vertikalen Transistors gelöst, daß die folgenden Schritte aufweist: Bilden eines unteren Dotiergebiets in einem Substrat; Bilden eines oberen Dotiergebiets in dem Substrat, oberhalb des unteren Dotiergebiets, wobei ein Kanalgebiet zwischen dem unteren Dotiergebiet und dem oberen Dotiergebiet gebildet wird; Bilden eines Isolationsgrabens neben dem Kanalgebiet; Bilden einer unteren Isolationsfüllung in dem Isolationsgraben; Bilden einer leitenden Schicht in dem Isolationsgraben auf der unteren Isolationsfüllung und Bilden einer oberen Isolationsfüllung in dem Isolationsgraben auf der leitenden Schicht, wobei die leitende Sshicht das Kanalgebiet elektrisch an das Substrat anschließt.

Von Vorteil ist dabei die schichtweise Herstellung der Füllung des Isolationsgrabens, da bei diesem Vorgehen die leitende Schicht an geeigneter Position in dem Isolationsgraben gebildet wird und das Kanalgebiet anschließt. Weiterhin ist von Vorteil, daß zur Herstellung der Füllung des Isolationsgraben keine Lithographieschritte notwendig sind, da die Schichtabscheidungen zur Bildung der Isolationsfüllungen und der leitenden Schicht als ganzflächige Prozesse ausgeführt werden können.

Ein weiterer vorteilhafter Verfahrensschritt sieht vor, daß die untere Isolationsfüllung so ausgebildet wird, daß der Isolationsgraben zunächst mit einem isolierenden Material gefüllt wird, welches anschließend an der Substratoberfläche planarisiert wird und mittels eines Rückätzschritts in den Isolationsgraben eingesenkt wird. Dieser Verfahrensschritt hat den Vorteil, daß er mit herkömmlichen Methoden zur Herstellung von Isolationsgrabenfüllungen durchgeführt werden kann. Zusätzlich wird allerdings ein Einsenkprozess durchgeführt, der in vorteilhafter Weise bis zu einer Tiefe durchgeführt wird, die das Kanalgebiet freilegt.

Ein weiterer vorteilhafter Verfahrensschritt sieht vor, daß die leitende Schicht mittels eines Sputter-Verfahrens auf die untere Isolationsfüllung aufgebracht wird. Durch diesen Prozeß ist eine selektive Bildung der leitenden Schicht auf der unteren Isolationsfüllung möglich. Durch sogenannte Rücksputterprozesse wird zusätzlich der Grad der Bodenbedeckung verstärkt, so daß mit einem Ätzprozeß das aufgesputterte Material von den Seitenwänden des Isolationsgrabens entfernt werden kann und eine leitende Schicht auf dem Boden des Isolationsgrabens erhalten bleibt.

Weitere Ausgestaltungen der Erfindung sind in den Unteransprüchen angegeben.

Die Erfindung wird nachfolgend mit Ausführungsbeispielen anhand von Zeichnungen näher erläutert.

In den Figuren zeigen:
- Figur 1: eine erfindungsgemäße Anordnung mit vertikalem Transistor und Isolationsgraben;
- Figur 2: eine weitere erfindungsgemäße Anordnung mit vertikalem Transistor, Grabenkondensator und Isolationsgraben;
- Figur 3: eine Anordnung mit Speicherzellen zur Herstellung eines Isolationsgrabens;
- Figuren 4 bis 9: die Speicherzellenanordnung nach Figur 3 gemäß einer Prozessierungsreihenfolge.

In den Figuren bezeichnen gleiche Bezugszeichen gleiche bzw. funktionsgleiche Elemente.

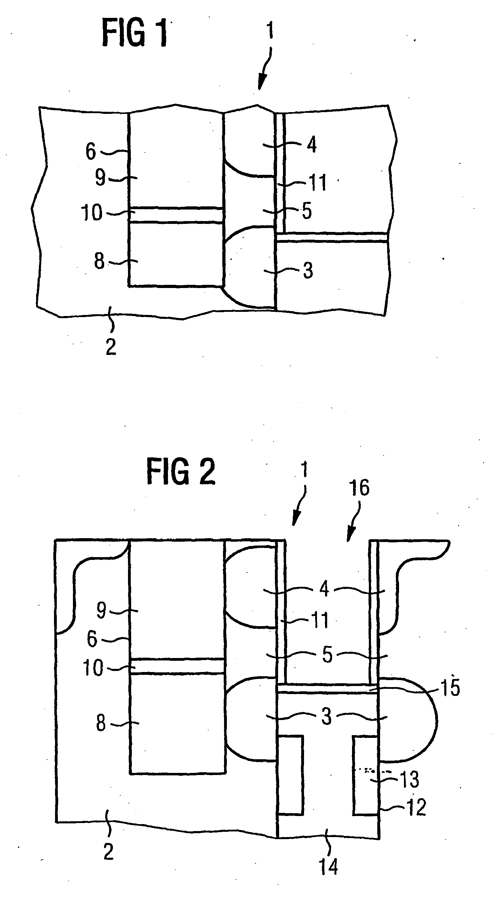

Mit Bezug auf Figur 1 ist eine erste Ausgestaltung der Erfindung dargestellt. Es ist ein vertikaler Transistor 1 in einem Substrat 2 gebildet. Das Substrat 2 besteht üblicherweise aus schwach dotiertem Silizium, wie z.B. schwach n-dotiertem oder schwach p-dotiertem Silizium. Der vertikale Transistor 1 besteht aus einem unteren Dotiergebiet 3, welches eine hohe Dotierung aufweist und einem oberen Dotiergebiet 4, welches ebenfalls eine hohe Dotierung aufweist. Das obere Dotiergebiet 4 ist oberhalb des unteren Dotiergebiet 3 angeordnet. Das obere Dotiergebiet ist beispielsweise das Drain-Gebiet des vertikalen Feldeffekttransistors und das untere Dotiergebiet ist beispielsweise das Source-Gebiet des Feldeffekttransistors.

Zwischen dem unteren Dotiergebiet 3 und dem oberen Dotiergebiet 4 ist ein Kanalgebiet 5 gebildet. An das Kanalgebiet 5 grenzt ein Gate-Oxid 11 an, das üblicherweise aus Siliziumoxid gebildet ist. Neben dem vertikalen Transistor 1 ist in dem Substrat 2 ein Isolationsgraben 6 ausgebildet. Der Isolationsgraben 6 ist in diesem Ausführungsbeispiel so angeordnet, daß er an das obere Dotiergebiet 4 an den Kanal und an das untere Dotiergebiet 3 angrenzt. Der Isolationsgraben 6 ist in seinem unteren Bereich mit einer unteren Isolationsfüllung 8 gefüllt, die beispielsweise aus einem Siliziumoxid besteht. Weiterhin befindet sich in dem Isolationsgraben 6 oberhalb der unteren Isolationsfüllung 8 eine leitende Schicht 10. Die leitende Schicht 10 ist in diesem Ausführungsbeispiel aus einer dotierten polykristallinen Siliziumschicht gebildet. Ebenfalls sind Materialien wie undotiertes Silizium, amorphes Silizium, dotiertes Silizium, Wolframnitrid, Titannitrid, Tantalnitrid oder auch ein Silizid zur Bildung der leitenden Schicht 10 verwendbar. Oberhalb der leitenden Schicht 10, ebenfalls in dem Isolationsgaben 6, ist die obere Isolationsfüllung 9 angeordnet. Die obere Isolationsfüllung 9 besteht beispielsweise aus Siliziumoxid.

Die leitende Schicht 10 hat die Funktion, das Kanalgebiet 5 an das Substrat 2 anzuschließen. Dadurch ist es möglich, Aufladungseffekt in dem Kanalgebiet 5 zu vermeiden, da Ladungen aus dem Kanalgebiet durch die leitende Schicht 10 in das Substrat 2 abgeleitet werden können. In dem in Figur 1 dargestellten Ausführungsbeispiel wäre das Kanalgebiet 5 ohne die leitende Schicht 10 rundherum von dem Isolationsgraben 6 dem Gate-Oxid 11, dem unteren Dotiergebiet 3 und dem oberen Dotiergebiet 4 isoliert. Besonders vorteilhaft ist es, den vertikalen Transistor als Ringtransistor um einen Graben herum zu bilden.

Ein Verfahren zur Herstellung der in Figur 1 dargestellten Anordnung bildet zunächst den vertikalen Transistor 1 in dem das untere Dotiergebiet 3 und das obere Dotiergebiet 4 durch Einbringen von Dotierstoff gebildet werden, der in das Substrat 2 hinein diffundiert. Anschließend wird neben dem oberen Dotiergebiet 4, neben dem Kanalgebiet 5 und neben dem unteren Dotiergebiet 3 der Isolationsgraben 6 in das Substrat 2 hinein geätzt. Üblicherweise werden die Seitenwände des Isolationsgrabens 6 in einer Prozeßkammer mit Hilfe eines Temperaturschritts und oxidierender Atmosphäre thermisch oxidiert. Anschließend wird der Isolationsgraben 6 vollständig mit einem Oxid gefüllt, welches sich auch auf der Oberfläche des Substrats 2 bildet. In einem anschließenden CMP-Schritt (Chemical Mechanical Polishing) wird die auf der Oberfläche gebildete Oxidschicht entfernt, so daß das Oxid in den Isolationsgraben 6 verbleibt. In einem nachfolgenden Ätzschritt wird das Oxid in dem Isolationsgraben 6 eingesenkt. Dazu eignet sich z.B. ein Naßätzprozeß mit Flußsäure. Durch eine geeignete Ätzzeit stellt sich die Ätztiefe in dem Isolationsgraben 6 so ein, daß die Oberkante des unteren Isolationsfüllung 8 auf der Höhe des Kanalgebiets 5 liegt. Durch den Ätzprozeß sind die oberen Seitenwände des Isolatiosgrabens 6 freigelegt, so daß an diesen Stellen das Siliziumsubstrat die Oberfläche des Isolationsgrabens bildet.

Die anschließende Bildung der leitenden Schicht 10 ist auf verschiedene Arten möglich. In diesem Ausführungsbeispiel wird eine Polysiliziumschicht ganzflächig auf dem Substrat abgeschieden, so daß der Isolationsgraben 6 mit Polysilizium gefüllt wird, das sich ebenfalls auf der Substratoberfläche bildet. In einem anschließenden CMP-Prozeß wird das Polysilizium von der Oberfläche des Substrats 2 entfernt und das in dem Isolationsgraben 6 verbleibende Polysilizium in einem anschließenden Rückätzprozeß so weit in den Isolationsgraben 6 eingesenkt, daß eine leitende Schicht 10 oberhalb der unteren Isolationsfüllung 8 gebildet wird. Optional kann vor der Bildung der leitenden Schicht 10 ein Liner unter der leitenden Schicht gebildet werden. Der Liner hat dabei die Aufgabe, als Diffusionsbarriere zwischen der leitenden Schicht 10 und dem Kanalgebiet 5 zu wirken. Der Rückätzprozeß kann z.B. mit einer anisotropen Ätzung durchgeführt werden, welche die gleiche Ätzmaske verwendet, die zur Bildung des Isolationsgrabens 6 verwendet wurde. Dadurch ist sichergestellt, daß der des Polysilizium-Einsenkprozeß in dem Isolationsgraben selbstjustiert zum Isolationsgraben stattfindet.

Eine weitere Möglichkeit, die leitende Schicht 10 zu bilden, besteht in der Verwendung eines Sputter-Verfahrens. Als Sputter-Verfahren eignet sich besonders ionisiertes Sputtern, bei dem das aufzusputternde Material mittels eines Hochfrequenzmagnetfeldes ionisiert wird und so gerichtet und durch ein elektrisches Feld beschleunigt, bevorzugt auf den Boden des Isolationsgrabens 6 abgeschieden wird. Weiterhin wird bei sogenanntem Rücksputtern die Bodenbedeckung des Isolationsgrabens verbessert. Dazu wird nicht nur eine Hochfrequenzwechselspannung an die Sputter-Kathode, sondern ebenfalls eine Hochfrequenzspannung an der Anode angeschlossen, auf der das Substrat angeordnet ist. Das sogenannte Rücksputtern oder auch Bias-Sputtern genannt, führt dazu, daß Sputter-Material vorzugsweise auf dem Boden eines Grabens angeordnet wird.

Anschließend wird der Isolationsgraben 6 mit der oberen Isolationsfüllung 9 aufgefüllt. Dazu sind wiederum übliche Verfahren zur Bildung eines Isolationsmaterials in einem Graben geeignet. Beispielsweise wird eine thermische Oxidation der Seitenwände des Isolationsgrabens 6 und der leitenden Schicht 10 durchgeführt. Danach wird eine Oxidschicht in dem Isolationsgraben 6 oberhalb der leitenden Schicht 10 angeordnet, die den Isolationsgraben 6 auffüllt und ebenfalls auf der Oberfläche des Substrats 2 gebildet wird. Mit einem anschließenden CMP-Prozeß wird das auf der Oberfläche des Substrats 2 befindliche isolierende Material entfernt, so daß letztendlich die obere Isolationsfüllung 9 in dem Isolationsgraben 6 angeordnet ist.

Mit Bezug auf Figur 2 ist ein zweites Ausführungsbeispiel eines erfindungsgemäßen vertikalen Transistors dargestellt. In einem Substrat 2 ist ein vertikaler Transistor 1 ausgebildet. Der vertikale Transistor ist in diesem Ausführungsbeispiel als ringförmiger Transistor um einen Graben 12 herum gebildet. Der vertikale Transistor 1 besteht aus einem unteren Dotiergebiet 3 und einem oberen Dotiergebiet 4, welches oberhalb des unteren Dotiergebietes 3 angeordnet ist. Zwischen dem unteren Dotiergebiet 3 und dem oberen Dotiergebiet 4 ist ein Kanalgebiet 5 angeordnet. Bei dem Substrat 2 handelt es sich üblicherweise um Silizium. Das Substrat 2 kann beispielsweise leicht mit p- oder n-Dotierstoff dotiert sein.
Das untere Dotiergebiet 3 und das obere Dotiergebiet 4 werden in dem Substrat 2 durch Einbringen von Dotierstoff gebildet. Neben dem vertikalen Transistor 1 ist ein Isolationsgraben 6 angeordnet. Der Isolationsgraben 6 ist in seinem unteren Bereich mit einer unteren Isolationsfüllung 8 gefüllt. Oberhalb der unteren Isolationsfüllung 8 ist eine leitende Schicht 10 angeordnet. Die leitende Schicht 10 verbindet das Substrat 2 und das Kanalgebiet 5 miteinander. Oberhalb der leitenden Schicht 10 ist eine obere Isolationsfüllung 9 in dem Isolationsgraben 6 angeordnet. Die obere Isolationsfüllung 9 grenzt in diesem Ausführungsbeispiel an das obere Dotiergebiet 4 an. Die untere Isolationsfüllung 8 grenzt in diesem Ausführungsbeispiel an das untere Dotiergebiet an. Der in Figur 2 dargestellte vertikale Transistor 1 wird als Auswahltransistor in einer DRAM-Speicherzelle verwendet. Der Grabenkondensator 16 ist in dem Graben 12 angeordnet. In dem oberen Bereich des Grabens 12 ist ein Isolationskragen 13 an der Grabeninnenwand angeordnet. Weiterhin ist der Graben 12 mit einer leitenden Grabenfüllung 14 aufgefüllt, die bis an das untere Dotiergebiet 3 heranreicht. Auf der leitenden Grabenfüllung 14 befindet sich eine isolierende Deckschicht 15.

Ein Herstellungsverfahren des in Figur 2 dargestellten Ausführungsbeispiels sieht zunächst die Bildung eines Grabenkondensators vor. Dazu wird ein Graben 12 in ein Substrat 2 geätzt. In dem unteren Bereich des Grabens 12 wird auf herkömmlich bekannte Weise ein Grabenkondensator gebildet. Dabei wird in dem oberen Bereich des Grabenkondensators 16 ein Isolationskragen 13 gebildet und der Graben wird in dem Bereich des Grabenkondensators mit einer leitenden Grabenfüllung 14 gefüllt.

Üblicherweise wird das untere Dotiergebiet 3 mittels eines Temperaturschritts gebildet, bei dem Dotierstoff aus der leitenden Grabenfüllung 14 in das Substrat 2 diffundiert. Das obere Dotiergebiet 4 wird z.B. mittels einer Implantation von Dotierstoff in das Substrat 2 hergestellt.

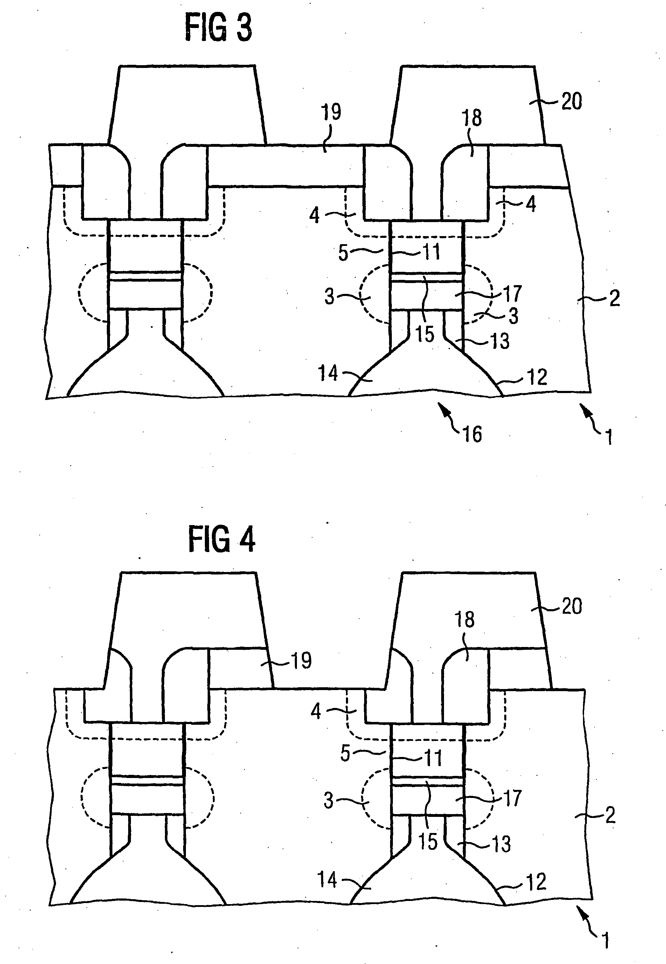

Mit bezug auf Figur 3 bis Figur 9 wird ein Herstellungsverfahren eines erfindungsgemäßen vertikalen Transistors beschrieben. Die Figuren 3 bis 9 stellen dabei den jeweiligen Prozessierungsfortschritt dar.

In Figur 3 ist ein vertikaler Transistor 1 in einem Substrat 2 dargestellt. Der vertikale Transistor 1 weist ein unteres Dotiergebiet 3, und ein oberes Dotiergebiet 4 auf, die beide ringförmig um einen Graben 12 angeordnet sind. Zwischen dem unteren Dotiergebiet 3 und dem oberen Dotiergebiet 4 ist ein Kanalgebiet 5 angeordnet. Ebenfalls ist in dem Graben 12 ein Gate-Oxid 11 neben dem Kanalgebiet 5 angeordnet. Der Graben 12 ist mit einer leitenden Grabenfüllung 14 gefüllt. In dem oberen Bereich des Grabens 12, der in diesem Fall flaschenförmig ausgebildet ist, befindet sich ein Isolationskragen 13. Oberhalb des Isolationskragens 13 ist ein leitender Dekkel 17 angeordnet. Der leitende Deckel 17 ist mit dem unteren Dotiergebiet 3 verbunden. Auf dem leitenden Deckel 17 befindet sich eine isolierende Deckschicht 15. In diesem Ausführungsbeispiel ist das Substrat 2 z.B. aus schwach dotiertem Silizium gebildet. Das untere Dotiergebiet 3 und das obere Dotiergebiet 4 sind als stark dotierte Gebiete in dem Substrat 2 ausgebildet. Oberhalb des oberen Dotiergebietes 4 ist ein dielektrischer Ring 18 angeordnet. Oberhalb des Substrats, neben dem Graben 12 ist eine dielektrische Schicht 19 angeordnet. In diesem Ausführungsbeispiel besteht die dielektrische Schicht 19 und der dielektrische Ring 18 aus Siliziumnitrid. Oberhalb dieser Anordnung ist eine Maske 20 gebildet, die bereits strukturiert ist.

Ein Herstellungsverfahren der in Figur 3 dargestellten Anordnung stellt ein Substrat 2 bereit, in das zunächst mit einer geeigneten Maske ein Graben 12 hineingeätzt wird. Der Graben 12 ist in diesem Beispiel in seinem unteren Bereich zur Flaschenform vergrößert. Mit aus der Literatur bekannten Verfahren wird der Grabenkondensator in dem unteren Bereich des Grabens 12 gebildet. Ebenfalls wird ein Isolationskragen 13 in dem Halsbereich des flaschenförmigen Grabens 12 gebildet. Anschließend wird der Graben 12 mit einer leitenden Grabenfüllung 14 aufgefüllt. In einem nachfolgenden Einsenkprozess wird sowohl der Isolationskragen 13 sowie die leitende Grabenfüllung 14 in den Graben eingesenkt. Oberhalb der eingesenkten leitenden Grabenfüllung und des eingesenkten Isolationskragens 13 wird der leitende Deckel 17 gebildet. Dies ist z.B. durch Abscheidung einer hochdotierten Polysiliziumschicht möglich. Die hochdotierte Polysiliziumschicht wird anschließend ebenfalls in den Graben 12 eingesenkt, so daß der leitende Deckel 17 entsteht. In diesem Ausführungsbeispiel ist der leitende Deckel 17 aus hochdotiertem Silizium gebildet, so daß in einem Temperaturschritt das untere Dotiergebiet 3 in dem Substrat 2 durch Ausdiffusion von Dotierstoff gebildet wird. Auf dem leitenden Deckel 17 wird eine isolierende Deckschicht 15 gebildet. Anschließend wird mittels Implantation das obere Dotiergebiet 4 in dem Graben 12 gebildet.

Mittels einer Nitridschichtabscheidung und anschließender Rückätzung (Spacerbildung) wird der dielektrische Ring 18 aus Siliziumnitrid gebildet. Es wird ebenfalls die dialektische Schicht 19 aus Siliziumnitrid gebildet. Anschließend wird eine photosensitive Schicht auf die Anordnung aufgebracht, belichtet und entwickelt, so daß die in Figur 3 dargestellte Maske 20 entsteht.

Mit Bezug auf Figur 4 wird die Maske 20 für einen ersten Ätzprozeß verwendet. Dieser Ätzprozeß ätzt vornehmlich die freigelegte dielektrische Schicht 19 und den freigelegten dielektrischen Ring 18. Bei der Ätzung handelt es sich um eine anisotrope Ätzung, so daß ein Graben mit annähernd senkrechten Flanken entsteht. Diese Ätzung kann selektiv durchgeführt werden, da der dielektrische Ring 18 und die dielektrische Schicht 19 aus Siliziumnitrid gebildet sind.

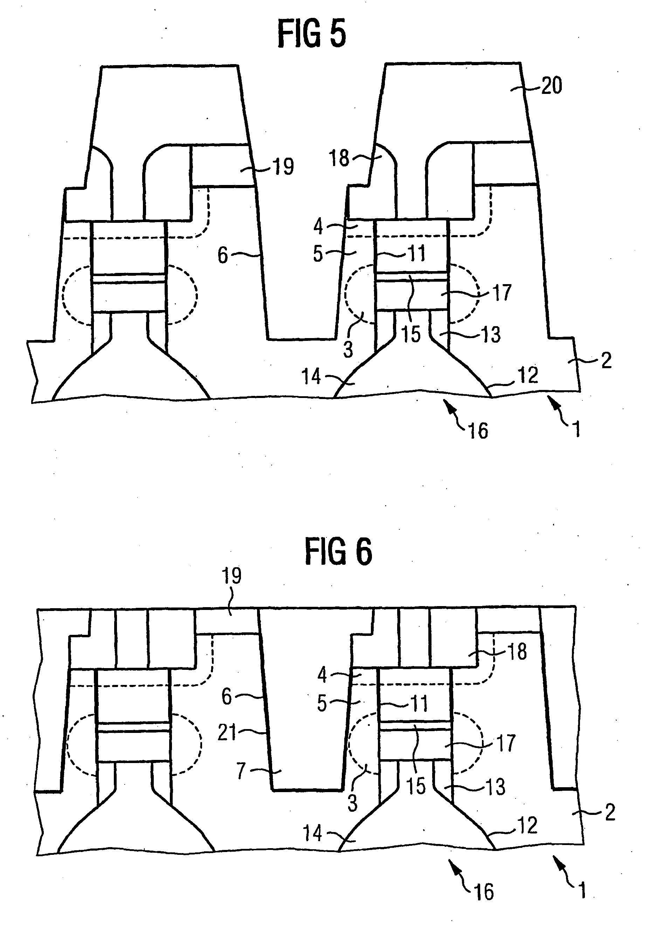

Mit Bezug auf Figur 5 wird der Isolationsgraben 6 in das Substrat 2 geätzt. Diese Ätzung verwendet den dielektrischen Ring 18 und die dielektrische Schicht 19 als Ätzmaske. Eine entsprechend selektive Ätzung führt zu einem sehr geringen Ätzabtrag der aus Siliziumnitrid bestehenden dielektrischen Schicht 19 und des dielektrischen Rings 18 und zu einem hohen Ätzabtrag des Substrats 2.

Mit Bezug auf Figur 6 wird zunächst die Maske 20 von der Oberfläche entfernt und eine thermische Oxidation des freigelegten Substrats 2 durchgeführt. Dabei entsteht eine Siliziumoxidschicht. Anschließend wird mittels einer CVD-Abscheidung (Chemical Vapour Deposition) oder auch mittels eines HDP-Prozessschritts (High Density Plasma), bei dem es sich ebenfalls um einen CVD-Prozeß handelt, eine Siliziumoxidschicht abgeschieden. Die Siliziumoxidschicht bildet sich dabei in dem Isolationsgraben 6 und auf der Oberfläche des Substrats.

Anschließend wird mittels eines CMP-Prozesses die Siliziumoxidschicht von der Oberfläche entfernt und die Oberfläche planarisiert.

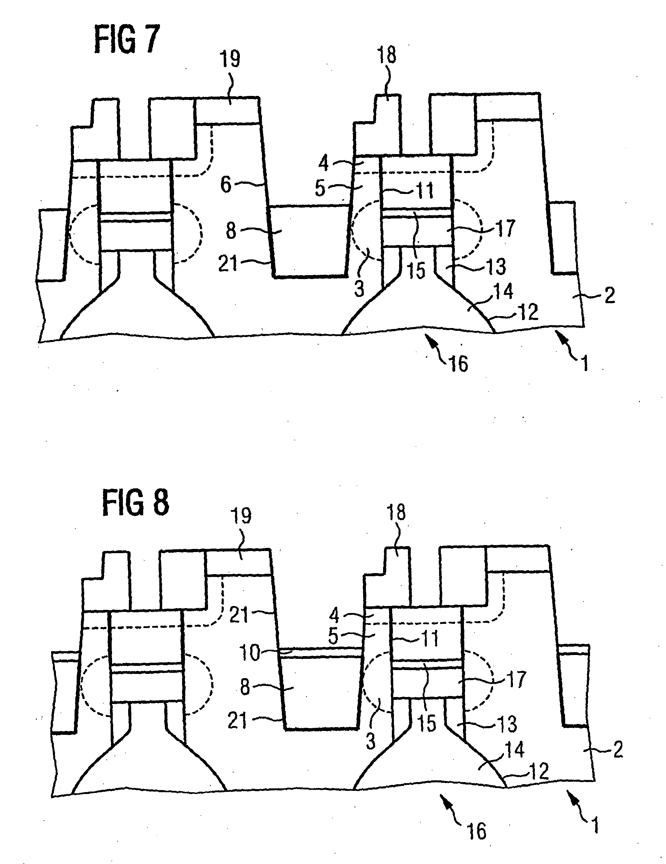

Mit Bezug auf Figur 7 wird das isolierende Material 7 in den Graben 6 eingesenkt. Dabei entsteht die untere Isolationsfüllung 8. Zum Einsenken ist beispielsweise ein naßchemischer Ätzprozeß mit Flußsäure verwendbar.

Mit Bezug auf Figur 8 wird eine Polysiliziumschicht auf das Substrat abgeschieden. Dabei wird der Isolationsgraben 6 mit der Polysiliziumschicht gefüllt, die sich ebenfalls auf der Oberfläche des Substrats niederschlägt. Mit einem anschließenden CMP-Prozeß wird die Polysiliziumschicht von der Oberfläche der Substrats entfernt, planarisiert und anschließend in den Graben 6 eingesenkt, so daß die leitende Schicht 10 entsteht. Anschließend wird eine thermische Oxidation durchgeführt, welche die freigelegten Seitenwände des Isolationsgraben 6 und die Oberfläche der leitenden Schicht 10 Oxidiert und eine Oxidschicht 21 bildet.

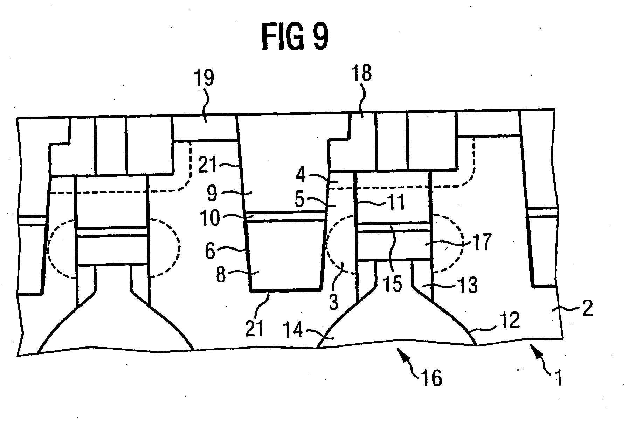

Mit Bezug auf Figur 9 wird eine Oxidschicht abgeschieden, die den Graben 6 auffüllt und sich auf der Oberfläche des Substrats niederschlägt. In einem anschließenden CMP-Prozeß wird die Oxidschicht von der Substratoberfläche entfernt und dabei die obere Isolationsfüllung 9 gebildet.

## Patentansprüche

1. vertikaler Transistor (1) in einem Substrat (2) mit:
- einem unteren Dotiergebiet (3), das in dem Substrat (2) angeordnet ist;
- einem oberen Dotiergebiet (4), das in dem Substrat (2) oberhalb des unteren Dotiergebiets (3) angeordnet ist;
- mit einem Kanalgebiet (5), das zwischen dem unteren Dotiergebiet (3) und dem oberen Dotiergebiet (4) angeordnet ist;
- mit einem Isolationsgraben (6), der mit einem isolierenden Material (7) gefüllt ist und an das Kanalgebiet (5) heranreicht,
**dadurch gekennzeichnet, daß**
der Isolationsgraben (6) eine untere Isolationsfüllung (8) unterhalb einer oberen Isolationsfüllung (9) und eine leitende Schicht (10) zwischen der unteren Isolationsfüllung (8) und der oberen Isolationsfüllung (9) aufweist, wobei die leitende Schicht (10) das Kanalgebiet (5) elektrisch an das Substrat (2) anschließt.

2. Transistor (1) nach Anspruch 1,
**dadurch gekennzeichnet, daß**
die obere Isolationsfüllung (9) an das obere Dotiergebiet (4) heranreicht.

3. Transistor (1) nach Anspruch 1 oder 2,
**dadurch gekennzeichnet, daß**
die untere Isolationsfüllung (8) an das untere Dotiergebiet (3) heranreicht.

4. Transistor (1) nach einem der Ansprüche 1 bis 3,
**dadurch gekennzeichnet, daß**
die leitende Schicht (10) aus Silizium, dotiertem Silizium, polykristallinem Silizium, amorphem Silizium, Wolframnitrid, Titannitrid, Tantalnitrid oder einem Silizid gebildet ist.

5. Transistor (1) nach einem der Ansprüche 1 bis 4,
**dadurch gekennzeichnet, daß**
die untere Isolationsfüllung (8) und die obere Isolationsfüllung (9) zumindest teilweise aus Siliziumoxid, Siliziumnitrid und/oder Siliziumoxynitrid gebildet sind.

6. Verfahren zur Herstellung eines vertikalen Transistors (1) mit den Schritten:
- Bilden eines unteren Dotiergebiets (3) in einem Substrat (2);
- Bilden eines oberen Dotiergebiets (4) in dem Substrat (2) oberhalb des unteren Dotiergebiets (3), wobei ein Kanalgebiet (5) zwischen dem unteren Dotiergebiet (3) und dem oberen Dotiergebiet (4) gebildet wird;
- Bilden eines Isolationsgrabens (6) neben dem Kanalgebiet (5);
- Bilden einer unteren Isolationsfüllung (8) in dem Isolationsgraben (6);
- Bilden einer leitenden Schicht (10) in dem Isolationsgraben (6) auf der unteren Isolationsfüllung (8) und
- Bilden einer oberen Isolationsfüllung (9) in dem Isolationsgraben (6) auf der leitenden Schicht (10), wobei die leitende Schicht (10) das Kanalgebiet (5) elektrisch an das Substrat (2) anschließt.

7. Verfahren nach Anspruch 6,
**dadurch gekennzeichnet, daß**
die untere Isolationsfüllung (8) so gebildet wird, daß der Isolationsgraben (6) zunächst mit einem isolierenden Material (7) gefüllt wird, welches anschließend an der Substratoberfläche planarisiert wird und mittels eines Rückätzschritts in den Isolationsgraben (6) eingesenkt wird.

8. Verfahren nach einem der Ansprüche 6 oder 7,
**dadurch gekennzeichnet, daß**
die leitende Schicht (10) mittels eines Sputter-Verfahrens auf die untere Isolationsfüllung (8) aufgebracht wird.

## Claims

1. Vertical transistor (1) in a substrate (2) comprising:
- a lower doping region (3) disposed in the substrate (2);
- an upper doping region (4) disposed in the substrate above the lower doping region;
- with a channel region (5) disposed between the lower doping region (3) and the upper doping region (4);
- with an isolation trench (6) filled with an insulating material (7) and extending to the channel region (5),
**characterized in that**
the isolation trench (6) comprises a lower insulation filling (8) below an upper insulation filling (9) and a conductive layer (10) between the lower insulation filling (8) and the upper insulation filling (9), wherein the conductive layer (10) is electrically connecting the channel region (5) to the substrate (2).

2. Transistor (1) according to claim 1,
**characterized in that**
the upper insulation filling (9) extends to the upper doping region (4).

3. Transistor (1) according to claim 1 or 2,
**characterized in that**
the lower insulation filling (8) extends to the lower doping region (3).

4. Transistor (1) according to one of the claims 1 to 3,
**characterized in that**
the conductive layer (10) is formed of silicon, doped silicon, polycrystalline silicon, amorphous silicon, tungsten nitride, titanium nitride, tantalum nitride or a silicide.

5. Transistor according to one of the claims 1 to 4,
**characterized in that**
the lower insulation filling (8) and the upper insulation filling (9) at least partly are formed of silicon oxide, silicon nitride and/or silicon oxynitride.

6. Method for fabricating a vertical transistor (1) comprising the steps:
- forming a lower doping region (3) in a substrate (2);
- forming an upper doping region (4) in the substrate (2) above the lower doping region (3), wherein a channel region (5) is formed between the lower doping region (3) and the upper doping region (4);
- forming an isolation trench (6) next to the channel region (5);
- forming a lower insulation filling (8) in the isolation trench (6);
- forming a conductive layer (10) in the isolation trench (6) on the lower insulation filling (8) and
- forming an upper insulation filling (9) in the isolation trench (6) on the conductive layer (10), wherein the conductive layer (10) electrically connects the channel region (5) to the substrate (2).

7. Method according to claim 6,
**characterized in that**
the lower insulation filling (8) is formed such that the isolation trench (6) is initially filled with an insulating material (7) which subsequently is planarized at the substrate surface and recessed into the isolation trench (6) by an etchback step.

8. Method according to claim 6 or 7,
**characterized in that**
the conductive layer (10) is applied on the lower insulation filling (8) by a sputtering method.

## Revendications

1. Transistor vertical (1) dans un substrat (2) comprenant:
- une zone de dopage inférieure (3) disposée dans le substrat (2);
- une zone de dopage supérieure (4) disposée dans le substrat (2) au-dessus de la zone de dopage inférieure (3);
- avec une zone de canal (5) disposée entre la zone de dopage inférieure (3) et la zone de dopage supérieure (4);
- avec une tranchée d'isolation (6) remplissant avec un matériau insulé (7) et s'étendant jusqu'à la zone de canal (5); charactérisé par le fait que
la tranchée d'isolation (6) comprend un bourrage isolant inférieur (8) au-dessus d'un bourrage isolant supérieur (9) et une couche conductrice (10) entre le bourrage isolant inférieur (8) et le bourrage isolant supérieur (9), la couche conductrice (10) connectant la zone de canal (5) électriquement au substrat (2).

2. Transistor (1) selon la revendication 1,
charactérisé par le fait que
le bourrage isolant supérieur (9) s'étend jusqu'à la zone de dopage supérieure (4).

3. Transistor (1) selon la revendication 1 ou 2,
charactérisé par le fait que
le bourrage isolant inférieur (8) s'étend jusqu'à la zone de dopage inférieure (3).

4. Transistor (1) selon l'une des revendications 1 à 3, charactérisé par le fait que
la couche conductrice (10) est formée de silicium, silicium dopé, silicium polycristallin, silicium amorphe, nitrure tungstique, nitrure titane, nitrure tantale, ou siliciure.

5. Transistor (1) selon l'une des revendications 1 à 4, charactérisé par le fait que
le bourrage isolant inférieur (8) et le bourrage isolant supérieur (9) sont au moins partiellement formés de silicium oxyde, silicium nitrite et/ou silicium oxynitrite.

6. Procédé de production d'un transistor vertical (1) comprenant les étapes:
- formation d'une zone de dopage inférieure (3) dans un substrat (2);
- formation d'une zone de dopage supérieure (4) dans le substrat (2) au-dessus de la zone de dopage inférieure (3), une zone de canal (5) étant formée entre la zone de dopage inférieure (3) et la zone de dopage supérieure (4);
- formation d'une tranchée isolante (6) à côté de la zone de canal (5);
- formation d'un bourrage isolant inférieur (8) dans la tranchée isolante (6);
- formation d'une couche conductrice (10) dans la tranchée isolante (6) sur le bourrage isolant inférieur (8) et
- formation d'un bourrage isolant supérieur (9) dans la tranchée isolante (6) sur la couche conductrice (10), la couche conductrice (10) connectant la zone de canal (5) électriquement au substrat (2).

7. Procédé selon la revendication 6,
charactérisé par le fait que
le bourrage isolant inférieur (8) est formé de manière que la tranchée isolante (6) soit premièrement remplissée avec un matériau isolant (7), lequel est après planarisé au surface du substrat et gravé dans la tranchée isolante (6) par l'attaque en retrait.

8. Procédé selon la revendication 6 ou 7,
charactérisé par le fait que
la couche conductrice (10) est appliquée sur le bourrage isolant inférieur (8) par un procédé de pulvérisation cathodique.
